# EUROPÄISCHE PATENTSCHRIFT

(11) **EP 3 931 417 B1**
(45) Veröffentlichungstag und Bekanntmachung des Hinweises auf die Patenterteilung: **30.11.2022**
(21) Anmeldenummer: 20708416.1
(22) Anmeldetag: 13.02.2020
(51) Int. Cl.: E05B 9/08, E05B 15/02, E05B 63/04, E05C 9/00

(54) **SCHLIESSANORDNUNG FÜR EINEN SCHALTSCHRANK**
LOCKING DEVICE FOR A SWITCHGEAR CABINET
DISPOSITIF DE VERROUILLAGE POUR UNE ARMOIRE DE COMMANDE

(30) Priorität: 25.02.2019 DE 102019104733
(43) Veröffentlichungstag der Anmeldung: 05.01.2022
(73) Patentinhaber: Rittal GmbH & Co. KG, 35745 Herborn (DE)
(72) Erfinder: HERR, Jacob, 35745 Herborn (DE); BÄUMER, Carsten, 57258 Freudenberg (DE)
(74) Vertreter: Angerhausen, Christoph
(86) Internationale Anmeldenummer: PCT/DE2020/100099
(87) Internationale Veröffentlichungsnummer: WO 2020/173523

(56) Entgegenhaltungen:
- EP-A1- 0 446 566
- DE-A1- 19 853 694
- DE-A1-102017 114 094
- DE-U1-202006 003 304
- DE-U1-202007 014 083
- DE-U1-202018 107 399

## Beschreibung

Die Erfindung geht aus von einer Schließanordnung für einen Schaltschrank, die eine Schaltschranktür mit einem an der Innenseite der Schaltschranktür angeordneten Schubstangenverschluss aufweist. Der Schubstangenverschluss streckt sich von der Innenseite über ein Koppelstück durch die Schaltschranktür hindurch zur gegenüberliegenden Vorderseite der Schaltschranktür, an welcher das Koppelstück vorsteht. Über das Koppelstück kann ein Betätigungsglied an der Vorderseite der Schaltschranktür mit dem Schubstangenverschluss gekoppelt werden. Eine derartige Schließanordnung ist aus der DE 10 2017 114 094 A1 bekannt.

Die DE 20 2007 014083 U1 offenbart eine Schließanordnung für einen Schaltschrank, bei dem das Betätigungsglied über einen Griffadapter an der Vorderseite der Schaltschranktür festgelegt und mit dem Koppelstück gekoppelt ist, wozu die Schaltschranktür mindestens eine Adapterplatte aufweist, auf die der Griffadapter über mindestens einen Durchbruch formschlüssig aufgesetzt ist. Die Adapterplatte weist an ihrer dem Betätigungsglied zugewandten Seite ein Befestigungselement auf, mit dem das Betätigungsglied an der Adapterplatte festgelegt ist.

Die bekannten Schließanordnungen haben den Nachteil, dass für die Befestigung des Betätigungsglieds an der Vorderseite der Schaltschranktür eine ebene Auflagefläche an der Vorderseite für die sichere Fixierung des Betätigungsglieds in Bezug auf das Koppelstück bereitgestellt sein muss, etwa um eine wirkungsvolle Abdichtung des Betätigungsglieds gegenüber der Tür zur Erzielung einer gewünschten IP-Schutzklasse sicherzustellen. Dies wiederum schränkt jedoch die gestalterischen Möglichkeiten in Bezug auf die Schaltschranktür ein, was insbesondere im Bereich der IT-Schränke nachteilhaft ist.

Es ist daher die Aufgabe der Erfindung, eine Schließanordnung der eingangs beschriebenen Art derart weiterzuentwickeln, dass sie die flexible Ankopplung eines Betätigungsglieds an der Vorderseite der Schaltschranktür unabhängig von der Geometrie der Schaltschranktür erlaubt.

Diese Aufgabe wird durch eine Schließanordnung mit den Merkmalen des Anspruchs 1 gelöst. Die abhängigen Ansprüche betreffen jeweils vorteilhafte Ausführungsformen der Erfindung.

Demgemäß ist vorgesehen, dass ein Betätigungsglied über einen Griffadapter an der Vorderseite festgelegt und mit dem Koppelstück gekoppelt ist, wozu die Schaltschranktür mindestens eine Adapterplatte aufweist, auf die der Griffadapter über mindestens einen Durchbruch formschlüssig aufgesetzt ist. Dabei soll die Adapterplatte an ihrer dem Betätigungsglied zugewandten Seite ein Befestigungselement aufweisen, mit dem das Betätigungslied an der Adapterplatte festgelegt ist. Der Griffadapter ist dabei zwischen dem Betätigungsglied und der Schaltschranktür angeordnet.

Da die mechanische Befestigung des Betätigungsglieds an der Tür somit über die mindestens eine Adapterplatte erfolgt, die alle auf den Griff wirkenden Kräfte aufnimmt, und auf die der Griffadapter formschlüssig aufgesetzt ist, kann der Griffadapter im Wesentlichen frei gestaltet werden. Er kann somit beispielsweise einerseits eine Kontur der Schaltschranktür aufnehmen, indem der Griffadapter eine Auflageseite aufweist, die so gestaltet ist, dass der Griffadapter formschlüssig auf der Tür aufliegt. Andererseits ist der Griffadapter nur insoweit gestalterisch beschränkt, als dass er die Funktion aufweist, die ebene Auflage für die Montage des Betätigungsglieds bereitzustellen.

Der Griffadapter kann demgemäß dazu dienen, unabhängig von einer Geometrie der Schaltschranktür eine ebene Auflagefläche und damit eine ebene Montageseite für das Betätigungsglied zu schaffen, so dass hinsichtlich der Geometrie der Schaltschranktür eine hohe Gestaltungsfreiheit gegeben ist.

Die mindestens eine Adapterplatte, vorzugsweise sind mindestens zwei Adapterplatten vorgesehen, kann als eine Hülse ausgebildet sein. Die Hülse kann im Querschnitt senkrecht zu ihrer Längsrichtung ein Außengeometrie aufweisen, die entlang der Längsrichtung zumindest abschnittsweise und vorzugsweise über die gesamte Länge konstant ist. Die Adapterplatte, insbesondere die Hülse, kann an einer ihrer beiden gegenüber liegenden Stirnseiten ein Befestigungsmittel, etwa mindestens ein Innengewinde aufweisen, über die die Adapterplatte an der Schaltschranktür befestigt werden kann. An der gegenüberliegenden Stirnseite kann die Adapterplatte das Befestigungselement aufweisen, mit dem das Betätigungslied an der Adapterplatte festgelegt ist. Das Befestigungselement kann dazu eingerichtet sein, ein einfaches Montieren und Demontieren des Betätigungslieds zu erlauben, etwa nach dem Prinzip eines Aufrastgriffs, wie es grundsätzlich aus der DE 10 2017 114 094 A1 bekannt ist.

Das Befestigungselement kann mindestens ein Schlüsselloch und das Betätigungsglied mindestens einen Pilzkopf aufweisen, der über das Schlüsselloch in die Adapterplatte eingreift und das Schlüsselloch hintergreift.

Die Adapterplatte kann an ihrer dem Betätigungsglied zugewandten Seite eine Steckaufnahme für einen Arretierungsstift des Betätigungsglieds aufweisen. Dabei kann die Steckaufnahme angrenzend an das Schlüsselloch oder einteilig mit dem Schlüsselloch ausgebildet sein, etwa als ein symmetrisches Schlüsselloch mit einem zentralen aufgeweiteten Bereich für das Einstecken eines Pilzkopfes, und mit sich davon in entgegengesetzten Richtungen erstreckenden Langlöchern, von denen eines dazu dient, in einer Arretierungsposition des Betätigungsglieds von dem Pilzkopf hintergriffen zu werden, und von denen das andere dazu dient, einen Arretierungsstift aufzunehmen, um ein ungewolltes Demontieren des Betätigungsglieds zu vermeiden. Auch insoweit wird auf die DE 10 2017 114 094 A1 verwiesen.

Der Griffadapter kann ein Langloch aufweisen, entlang welches das Koppelstück durch den Griffadapter geführt ist. Dabei kann die Schaltschranktür zwei Adapterplatten und der Griffadapter zwei Durchbrüche aufweisen, die in Bezug auf das Langloch gegenüber liegend angeordnet sind.

Die Schaltschranktür kann ein weiteres Langloch aufweisen, entlang welches das Koppelstück durch die Schaltschranktür geführt ist, wobei das weitere Langloch und das Langloch versetzt zueinander angeordnet sind. Das Koppelstück kann dabei eine Z-Kantung zwischen dem Langloch und dem weiteren Langloch aufweisen. Über die Z-Kantung kann ein horizontaler Versatz der Ankopplung des Betätigungsglieds an das Koppelstück bereitgestellt sein.

Die mindestens eine Adapterplatte kann lösbar mit der Schaltschranktür, insbesondere mit einem Hohlprofil der Schaltschranktür verbunden sein, vorzugsweise mit dieser verschraubt und von der Innenseite der Schaltschranktür in ein Hohlprofil der Schaltschranktür eingesetzt sein. Die Adapterplatte kann an einer der Innenseite gegenüber liegenden Außenseite des Hohlprofils mit der Schaltschranktür verbunden sein.

Das Koppelstück kann sich durch ein Profil, vorzugsweise ein Hohlprofil, der Schaltschranktür hindurch erstrecken. Der Griffadapter kann an einer Längskante eine Rastkontur aufweisen, mit der er eine Profilkante an der Außenseite des Profils umgreift.

Der Griffadapter kann auf einer Außenseite eines Profils, vorzugsweise auf ein Hohlprofil der Schaltschranktür aufgesetzt sein, wobei sich die Außenseite gegenüber einer Schaltschranktürvorderseite unter einem spitzen Winkel erstreckt. Dabei kann der Griffadapter eine Auflageseite aufweisen, über die er auf der Außenseite aufliegt und die sich unter demselben spitzen Winkel zu einer Montageseite des Griffadapters erstreckt, über die das Betätigungsglied auf dem Griffadapter aufliegt, so dass sich die Montageseite parallel zu der Schaltschranktürvorderseite erstreckt.

Weitere Einzelheiten der Erfindung werden anhand der nachstehenden Figuren erläutert. Dabei zeigt
- Figur 1: eine erste Ausführungsform einer erfindungsgemäßen Schließanordnung mit von dem Griffadapter abgehobenem Betätigungsglied;
- Figur 2: eine Explosionsdarstellung der Schließanordnung gemäß Figur 1;
- Figur 3: eine weitere Ausführungsform einer erfindungsgemäßen Schließanordnung; und
- Figur 4: einen Horizontalquerschnitt durch eine weitere Ausführungsform einer erfindungsgemäßen Schließanordnung.

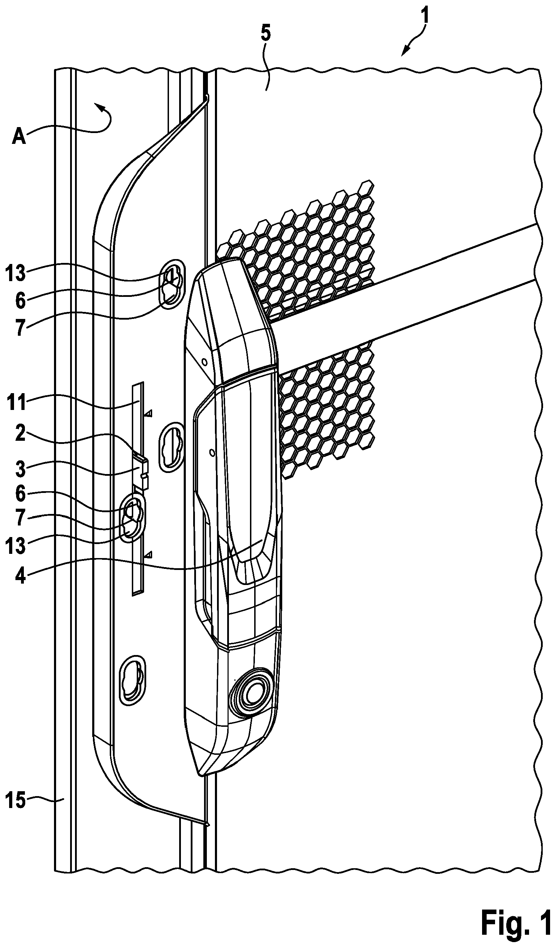

Die Figur 1 zeigt eine beispielhafte Ausführungsform einer Schließanordnung für einen

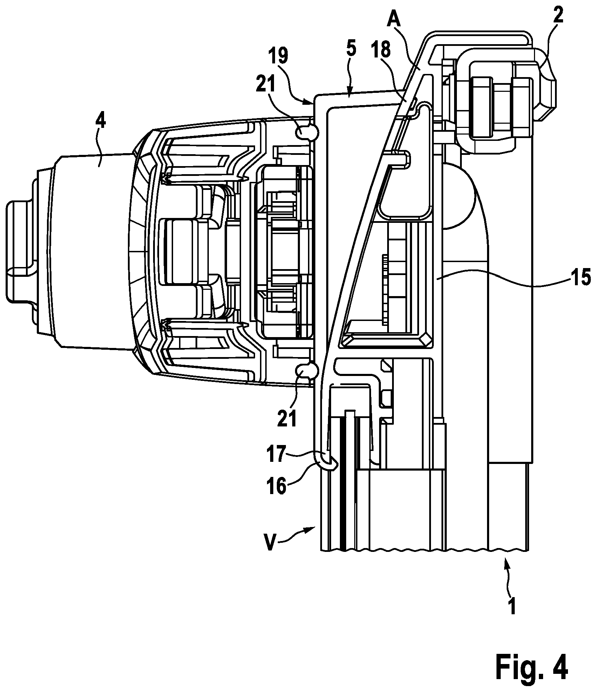

Schaltschrank. Diese weist eine Schaltschranktür 1 auf, die an ihrer Innenseite einen Schubstangenverschluss 2 (siehe auch Figur 4) aufweist, der über ein Koppelstück 3 an der dargestellten Vorderseite der Schaltschranktür 1 durch die Schaltschranktür 1 vorsteht. Über das Koppelstück 3 kann ein Betätigungsglied 4 mit dem Schubstangenverschluss gekoppelt werden. Das Betätigungsglied 4 ist von einem Griffadapter 5 abgehoben angeordnet. Wenn das Betätigungsglied 4 auf den Griffadapter aufgesetzt wird, koppelt das Koppelstück 3 mit einer Koppelplatte an der dem Koppelstück 3 zugewandten Montageseite des Betätigungsglieds 4. Ein geeignetes Betätigungsglied 4 ist in der DE 10 2017 114 094 A1 beschrieben.

Die Schaltschranktür 1 weist weiterhin zwei Adapterplatten 6 auf, auf die ein Griffadapter 5 über jeweils einen Durchbruch 13 formschlüssig aufgesetzt ist. An ihrer dem Betätigungsglied 4 zugewandten Seite weist die Adpaterplatte 6 ein Befestigungselement 7 auf, mit dem das Betätigungsglied 4 an der Adapterplatte 6 festgelegt ist. Das Befestigungselement 7 ist als ein Schlüsselloch ausgebildet, vorliegend als ein doppeltes Schlüsselloch mit einer zentralen Aufweitung an die sich gegenüberliegend jeweils ein Langloch anschließt. Auf diese Weise können die Adapterplatten 6 beziehungsweise die Befestigungselemente 7 sowohl für den Linksanschlag als auch den Rechtsanschlag der Schaltschranktür 1 verwendet werden und ebenso für die Aufnahme eines Arretierungsstifts des Betätigungsglieds dienen.

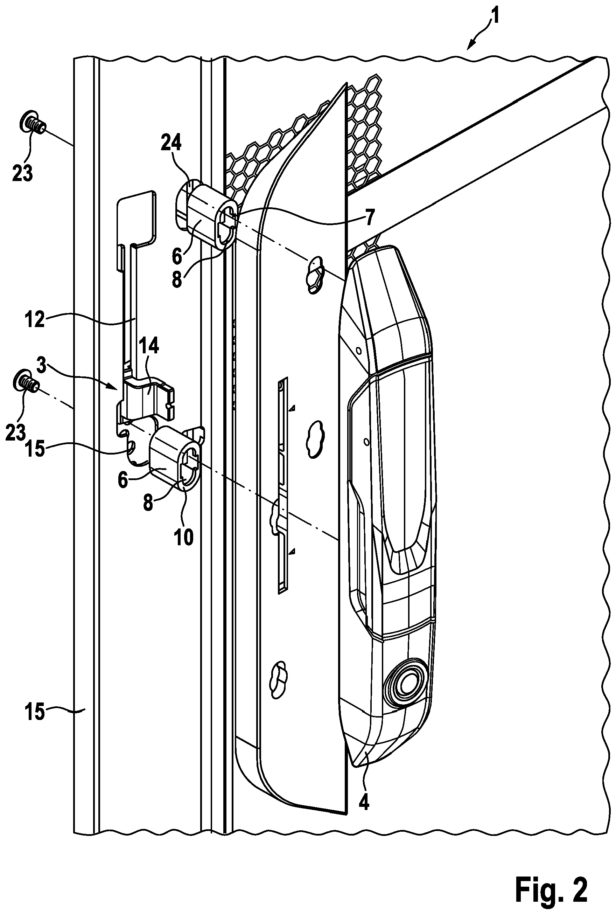

Mit Bezug auf Figur 2 ist dargestellt, dass die Schaltschranktür 1 an ihrer vertikalen Stirnseite, die von der Scharnierseite der Schaltschranktür 1 abgewandt ist, ein Hohlprofil 15 aufweist, in welches von der Außenseite des Hohlprofils 4 die Adapterplatten 6 über einen Durchlass 24 in das Hohlprofil 15 eingesetzt sind. Einer der beiden Durchlässe 15 ist an ein Langloch 12 endseitig angeformt. Entlang des Langlochs 12 ist das Koppelstück 3, insbesondere eine Z-Kantung des Koppelstücks 3 zwischen einer Schließposition und einer Offenposition des Schubschrankverschlusses geführt. Von der Innenseite des Hohlprofils 15 können die Adapterplatten 6 über jeweils mindestens eine Schraube 23 mit dem Hohlprofil 15 verschraubt werden.

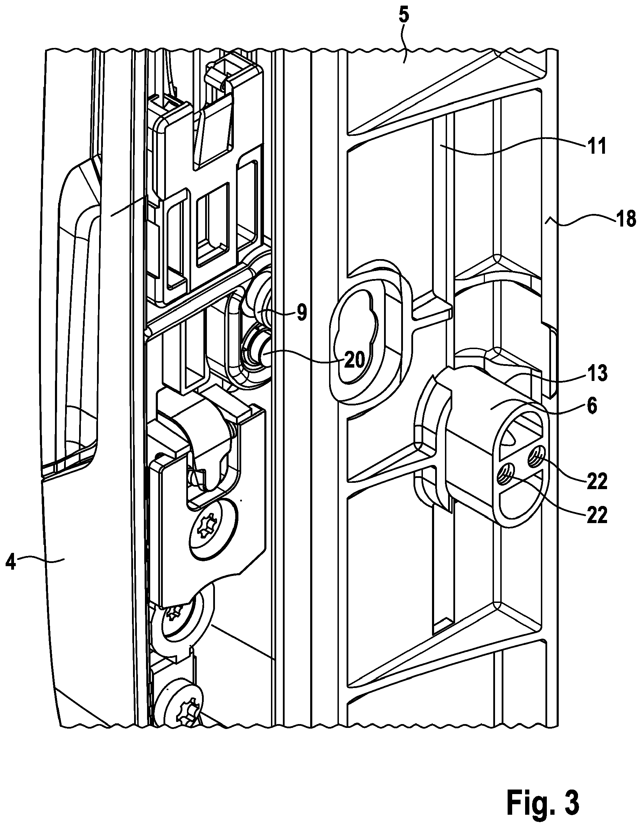

Wie mit Bezug auf Figur 3 gezeigt ist, kann dazu die Adapterplatter 6 an ihrer der Vorderseite des Hohlprofils 15 zugewandte Seite mindestens ein Innengewinde 22 und vorliegend zwei Innengewinde 22 aufweisen. Des Weiteren ist in Figur 3 zu erkennen, dass das Betätigungsglied 4 einerseits an seiner dem Griffadapter 5 zugewandten Seite einen Pilzkopf 9 und diesem beigeordnet einen Arretierungsstift 20 aufweist. Zur Aufnahme des Arretierungsstifts 20 in der korrekten Positionierung des Betätigungsglieds 4 in Bezug auf den Griffadapter 5 kann die Adapterplatte 6 an ihrer dem Betätigungsglied 4 zugewandten Seite eine Steckaufnahme 10 für den Arretierungsstift 20 des Betätigungsglieds 4 aufweisen; siehe Figur 1. Die Steckaufnahme 10 ist Bestandteil des symmetrisch ausgebildeten Schlüssellochs 8.

Mit Bezug auf Figur 4 ist zu erkennen, dass der Griffadapter 5 an einer Längskante eine Rastkontur 16 aufweist, mit der er eine Profilkante 17 an der Außenseite A des Hohlprofils 15 umgreift. Weiterhin ist der Griffadapter 5 auf einer Außenseite A des Hohlprofils 15 der Schaltschranktür 1 aufgesetzt. Die Außenseite A erstreckt sich gegenüber einer Schaltschranktürvorderseite V unter einem spitzen Winkel. Der Griffadapter 5 weist eine Auflageseite 18 auf (siehe auch Figur 3), über die er auf der Außenseite A aufliegt und die sich unter demselben spitzen Winkel zu einer Montageseite 19 des Griffadapters 5 erstreckt. Über die Montageseite 19 ist das Betätigungsglied 4 auf dem Griffadapter 5 aufgesetzt, so dass sich die Montageseite 19 parallel zu der Schaltschranktürvorderseite erstreckt.

### Bezugszeichenliste

- 1: Schaltschranktür
- 2: Schubstangenverschluss
- 3: Koppelstück
- 4: Betätigungsglied
- 5: Griffadapter
- 6: Adapterplatte
- 7: Befestigungselement
- 8: Schlüsseloch
- 9: Pilzkopf
- 10: Steckaufnahme
- 11: Langloch
- 12: weiteres Langloch
- 13: Durchbruch
- 14: Z-Kantung
- 15: Hohlprofil
- 16: Rastkontur
- 17: Profilkante
- 18: Auflageseite
- 19: Montageseite
- 20: Arretierungsstift
- 21: Dichtelement
- 22: Innengewinde
- 23: Schraube
- 24: Durchlass
- A: Außenseite
- V: Schaltschranktürvorderseite

## Patentansprüche

1. Schließanordnung für einen Schaltschrank, mit einer Schaltschranktür (1), die an ihrer Innenseite einen Schubstangenverschluss (2) aufweist, der über ein Koppelstück (3) durch die Schaltschranktür (1) hindurch zur Vorderseite der Schaltschranktür (1) vorsteht, wobei ein Betätigungsglied (4) über einen zwischen dem Betätigungsglied (4) und der Schaltschranktür (1) angeordneten und eine ebene Auflage für das Betätigungsglied (4) bildenden Griffadapter (5) an der Vorderseite festgelegt und mit dem Koppelstück (3) gekoppelt ist, wozu die Schaltschranktür (1) mindestens eine Adapterplatte (6) aufweist, auf die der Griffadapter (5) über mindestens einen Durchbruch (13) formschlüssig aufgesetzt ist, wobei die Adapterplatte (6) an ihrer dem Betätigungsglied (4) zugewandten Seite ein Befestigungselement (7) aufweist, mit dem das Betätigungsglied (4) an der Adapterplatte (6) festgelegt ist.

2. Schließanordnung nach Anspruch 1, bei der das Befestigungselement (7) mindestens ein Schlüsselloch (8) und das Betätigungsglied (4) mindestens einen Pilzkopf (9) aufweist, der über das Schlüsselloch (8) in die Adapterplatte (6) eingreift und das Schlüsselloch (8) hintergreift.

3. Schließanordnung nach Anspruch 1 oder 2, bei der die Adapterplatte (6) an ihrer dem Betätigungsglied (4) zugewandten Seite eine Steckaufnahme (10) für einen Arretierungsstift (20) des Betätigungsglieds (4) aufweist.

4. Schließanordnung nach Anspruch 3, bei der die Steckaufnahme (10) angrenzend an das Schlüsselloch (8) oder einteilig mit dem Schlüsselloch (8) ausgebildet ist.

5. Schließanordnung nach einem der vorangegangenen Ansprüche, bei der der Griffadapter (5) ein Langloch (11) aufweist, entlang welches das Koppelstück (3) durch den Griffadapter (5) geführt ist, wobei die Schaltschranktür (1) zwei Adapterplatten (6) und der Griffadapter (5) zwei Durchbrüche (13) aufweist, die in Bezug auf das Langloch (11) gegenüber liegend angeordnet sind.

6. Schließanordnung nach Anspruch 5, bei der die Schaltschranktür (1) ein weiteres Langloch (12) aufweist, entlang welches das Koppelstück (3) durch die Schaltschranktür (1) geführt ist, wobei das weitere Langloch (12) und das Langloch (11) versetzt zueinander angeordnet sind und das Koppelstück (3) eine Z-Kantung (14) zwischen dem Langloch (11) und dem weiteren Langloch (12) aufweist.

7. Schließanordnung nach einem der vorangegangenen Ansprüche, bei der die mindestens eine Adapterplatte (6) lösbar mit der Schaltschranktür (1) verbunden, vorzugsweise verschraubt und von der Innenseite der Schaltschranktür (1) in ein Hohlprofil (15) der Schaltschranktür (1) eingesetzt ist.

8. Schließanordnung nach Anspruch 7, bei der die Adapterplatte (6) an einer der Innenseite gegenüber liegenden Außenseite des Hohlprofils (15) mit der Schaltschranktür (1) verbunden ist.

9. Schließanordnung nach einem der vorangegangenen Ansprüche, bei der sich das Koppelstück (3) durch ein Profil (15), vorzugsweise ein Hohlprofil, der Schaltschranktür (1) hindurch erstreckt und der Griffadapter (5) an einer Längskante eine Rastkontur (16) aufweist, mit der er eine Profilkante (17) an der Außenseite des Profils (15) umgreift.

10. Schließanordnung nach einem der vorangegangenen Ansprüche, bei der der Griffadapter (5) auf eine Außenseite (A) eines Profils (15), vorzugsweise eines Hohlprofils (15) der Schaltschranktür (1) aufgesetzt ist, wobei sich die Außenseite (A) gegenüber einer Schaltschranktürvorderseite (V) unter einem spitzen Winkel erstreckt, und wobei der Griffadapter (5) eine Auflageseite (18) aufweist, über die er auf der Außenseite (A) aufliegt, die sich unter demselben spitzen Winkel zu einer Montageseite (19) des Griffadapters (5) erstreckt, über die das Betätigungsglied (4) auf dem Griffadapter (5) aufliegt, so dass sich die Montageseite (19) parallel zu der Schaltschranktürvorderseite erstreckt.

## Claims

1. A locking arrangement for a switchgear cabinet, having a switchgear cabinet door (1) which has on its inside a push-rod lock (2) which projects through the switchgear cabinet door (1) to the front side of the switchgear cabinet door (1) via a coupling piece (3), wherein an actuating member (4) is fixed to the front side via a handle adapter (5) arranged between the actuating member (4) and the switch cabinet door (1) and forming a flat support for the actuating member (4), and is coupled to the coupling piece (3), for which purpose the switch cabinet door (1) has at least one adapter plate (6), onto which the handle adapter (5) is placed in a form-fitting manner via at least one aperture (13), the adapter plate (6) having, on its side facing the actuating member (4), a fastening element (7), by means of which the actuating member (4) is fixed to the adapter plate (6).

2. The locking arrangement of claim 1, wherein the fastening element (7) has at least one keyhole (8) and the actuating member (4) has at least one mushroom head (9) that engages the adapter plate (6) via the keyhole (8) and engages behind the keyhole (8).

3. The locking arrangement according to claim 1 or 2, in which the adapter plate (6) has, on its side facing the actuating member (4), a plug-in receptacle (10) for a locking pin (20) of the actuating member (4).

4. The locking arrangement of claim 3, wherein the plug-in receptacle (10) is formed adjacent to the keyhole (8) or integrally with the keyhole (8).

5. The locking arrangement according to any one of the preceding claims, wherein the handle adapter (5) has an elongated hole (11) along which the coupling piece (3) is guided through the handle adapter (5), the switch cabinet door (1) having two adapter plates (6) and the handle adapter (5) having two apertures (13) which are arranged opposite one another with respect to the elongated hole (11).

6. The locking arrangement according to claim 5, in which the switch cabinet door (1) has a further elongated hole (12) along which the coupling piece (3) is guided through the switch cabinet door (1), the further elongated hole (12) and the elongated hole (11) being arranged offset with respect to one another and the coupling piece (3) having a Z-edge (14) between the elongated hole (11) and the further elongated hole (12).

7. The locking arrangement according to one of the preceding claims, in which the at least one adapter plate (6) is detachably connected, preferably screwed, to the control cabinet door (1) and is inserted from the inside of the control cabinet door (1) into a hollow profile (15) of the control cabinet door (1).

8. The locking arrangement according to claim 7, in which the adapter plate (6) is connected to the switch cabinet door (1) on an outer side of the hollow profile (15) opposite the inner side.

9. The locking arrangement according to one of the preceding claims, in which the coupling piece (3) extends through a profile (15), preferably a hollow profile, of the switch cabinet door (1) and the handle adapter (5) has a latching contour (16) on a longitudinal edge, with which it engages around a profile edge (17) on the outside of the profile (15).

10. The locking arrangement according to any one of the preceding claims, wherein the handle adapter (5) is placed on an outer side (A) of a profile (15), preferably a hollow profile (15) of the switch cabinet door (1), which outer side (A) extends at an acute angle relative to a switch cabinet door front side (V), and wherein the handle adapter (5) has a support side (18) via which it rests on the outer side (A), which extends at the same acute angle to a mounting side (19) of the handle adapter (5) via which the actuating member (4) rests on the handle adapter (5), so that the mounting side (19) extends parallel to the switch cabinet door front side.

## Revendications

1. Dispositif de fermeture pour une armoire de commande, avec une porte d'armoire de commande (1), qui comprend, sur son côté interne, une fermeture à tige de poussée (2), qui dépasse, par l'intermédiaire d'un élément de couplage (3) à travers la porte d'armoire de commande (1) vers le côté avant de la porte d'armoire de commande (1), dans lequel un organe d'actionnement (4) est fixé, par l'intermédiaire d'un adaptateur de poignée (5) disposé entre l'organe d'actionnement (4) et la porte d'armoire de commande (1) et formant un appui plat pour l'organe d'actionnement (4), sur le côté avant et est couplé avec l'élément de couplage (3), la porte d'armoire de commande (1) comprenant pour cela au moins une plaque d'adaptateur (6) sur laquelle l'adaptateur de poignée (5) est posé par complémentarité de forme au-dessus d'au moins une percée (13), dans lequel la plaque d'adaptateur (6) comprend, sur son côté orienté vers l'organe d'actionnement (4), un élément de fixation (7) avec lequel l'organe d'actionnement (4) est fixé à la plaque d'adaptateur (6).

2. Dispositif de fermeture selon la revendication 1, dans lequel l'élément de fixation (7) comprend au moins un trou de serrure (8) et l'organe d'actionnement (4) comprend au moins une tête de champignon (9) qui s'emboîte par l'intermédiaire du trou de serrure (8) dans la plaque d'adaptateur (6) et s'accroche par-derrière le trou de serrure (8).

3. Dispositif de fermeture selon la revendication 1 ou 2, dans lequel la plaque d'adaptateur (6) comprend, sur son côté orienté vers l'organe d'actionnement (4), un logement d'enfichage (10) pour une tige d'arrêt (20) de l'organe d'actionnement (4).

4. Dispositif de fermeture selon la revendication 3, dans lequel le logement d'enfichage (10) est réalisé de manière adjacente au trou de serrure (8) ou d'une seule pièce avec le trou de serrure (8).

5. Dispositif de fermeture selon l'une des revendications précédentes, dans lequel l'adaptateur de poignée (5) comprend un trou oblong (11) le long duquel l'élément de couplage (3) est guidé à travers l'adaptateur de poignée (5), dans lequel la porte d'armoire de commande (1) comprend deux plaques d'adaptateur (6) et l'adaptateur de poignée (5) comprend deux percées (13), qui sont disposées en face par rapport au trou oblong (11).

6. Dispositif de fermeture selon la revendication 5, dans lequel la porte d'armoire de commande (1) comprend un autre trou oblong (12) le long duquel l'élément de couplage (3) est guidé à travers la porte d'armoire de commande (1), dans lequel l'autre trou oblong (12) et le trou oblong (11) sont disposés de manière décalée entre eux, et l'élément de couplage (3) présente un pliage en Z (14) entre le trou oblong (11) et l'autre trou oblong (12).

7. Dispositif de fermeture selon l'une des revendications précédentes, dans lequel l'au moins une plaque d'adaptateur (6) est reliée de manière amovible avec la porte d'armoire de commande (1), de préférence vissé, et est inséré du côté interne de la porte d'armoire de commande (1) vers un profilé creux (15) de la porte d'armoire de commande (1).

8. Dispositif de fermeture selon la revendication 7, dans lequel la plaque d'adaptateur (6) est reliée, sur un côté externe en face du côté interne du profilé creux (15), avec la porte d'armoire de commande (1).

9. Dispositif de fermeture selon l'une des revendications précédentes, dans lequel l'élément de couplage (3) s'étend à travers un profilé (15), de préférence un profilé creux, de la porte d'armoire de commande (1) et l'adaptateur de poignée (5) comprend, sur une arête longitudinale, un contour d'encliquetage (16) avec lequel une arête de profilé (17) s'emboîte avec le côté externe du profilé (15).

10. Dispositif de fermeture selon l'une des revendications précédentes, dans lequel l'adaptateur de poignée (5) est posé sur un côté externe (A) d'un profilé (15), de préférence d'un profilé creux (15) de la porte d'armoire de commande (1), dans lequel le côté externe (A) s'étend avec un angle aigu par rapport à un côté avant de la porte d'armoire de commande (V) et dans lequel l'adaptateur de poignée (5) comprend un côté d'appui (18) par l'intermédiaire duquel il s'appuie sur le côté externe (A), qui s'étend avec le même angle par rapport à un côté de montage (19) de l'adaptateur de poignée (5), par l'intermédiaire duquel l'organe d'actionnement (4) repose sur l'adaptateur de poignée (5), de façon à ce que le côté de montage (19) s'étende parallèlement au côté avant de l'armoire de commande.
